# EUROPEAN PATENT APPLICATION

(11) **EP 0 838 192 A1**
(43) Date of publication of application: **29.04.1998**
(21) Application number: 97110750.3
(22) Date of filing: 01.07.1997
(51) Int. Cl.: A47L 15/46, A47L 15/42

(54) **Cover arrangement for a vacuum cleaner housing**

(30) Priority: 26.09.1996 IT TO960781
(71) Applicant: BITRON S.p.A., 10064 Pinerolo (Torino) (IT)
(72) Inventor: Strocco, Valter, 10137 Torino (IT); Isoardi, Elvio, 12020 Roccabruna (CN) (IT); Zanchetta, Fabio, 10040 Volvera (TO) (IT)
(74) Representative: Lotti, Giorgio

(57) **Abstract**

In an electronic control system for controlling the operational condition of the washing motor of a dish-washing machine, the washing motor (11, 11') is driven by an electronic circuit (10) connected to a microprocessor (16). A current sensing device (12), consisting of a shunt (13) and a π low-pass filter (17), is series connected to the driving branch of the electronic circuit (10) and is connected to the microprocessor (16) for carrying out constant and continuous control of the state of the current in the motor during the start-up phase and the maintenance phase and for detecting possible anomaly conditions.

## Description

The present invention refers to a system for controlling normal operation of the washing motor of a dish washing machine.

The system of this invention has been developed in order to guarantee maximum safety of the dishwashing machine in any working condition.

In the past, dish-washing machine manufacturers have had to solve several problems for guaranteeing an efficient and safe dishwashing machines, which should most of all wash perfectly. To accomplish such a result, hot and thorough washing has to be carried out. This is made possible by an efficient water pumping system. The above cited condition may become critical when, for various reasons, the motor of the washing pump is jammed so that the dishes do not get washed. In this circumstance, the safety of the dishwashing machine is in danger due to overheating of some electric components. In some cases, this can cause a fire.

To avoid these noxious effects, thermal safety devices have been series connected to the load. The safety devices operate before the danger condition occurs, but do not guarantee quick intervention that would prevent some plastic members mounted on the dishwashing machine from deteriorating.

As known, a resistor is fitted in the washing tank. This resistor is not covered by water but is cooled by the water coming out of the washing nozzles which are hydraulically activated by water pumped by said motor. Overheating occurs when the motor is jammed and the resistor is no longer cooled by the water jet.

There are mainly two causes for the jamming of the pump motor:
- after a prolonged inactivity of the diswashing machine a calcareous layer forms on the blades of the impeller, preventing the motor from starting;
- during washing or cleaning of the pump filter, deposits can get stuck between the blades of the impeller, jamming it.

For the aforecited reasons, an electronic control system has been proposed for guaranteeing continuous monitoring of the washing motor working conditions.

These and further objects which will be more apparent hereinafter are attained according to the present invention by the provision of an electronic control system for controlling the operational condition of the washing motor of a dish-washing machine of the type in which the washing motor is driven by an electronic circuit connected to a microprocessor, characterised in that a current sensing device, consisting of a shunt and a π low-pass filter, is series connected to the driving branch of the electronic circuit and is connected to the microprocessor for carrying out constant and continuous control of the state of the current in the motor during the start-up phase and the maintenance phase and for detecting possible anomaly conditions.

For a better understanding of the present invention, reference is made to the following detailed description of an exemplary embodiment considered in combination with the accompanying drawings in which:
- FIG. 1: is a diagrammatic representation of the operation of the motor;
- FIG. 2: is a block diagram of the electric connections of the motor; and
- FIG. 3: is a variant of the detail A of FIG. 2.

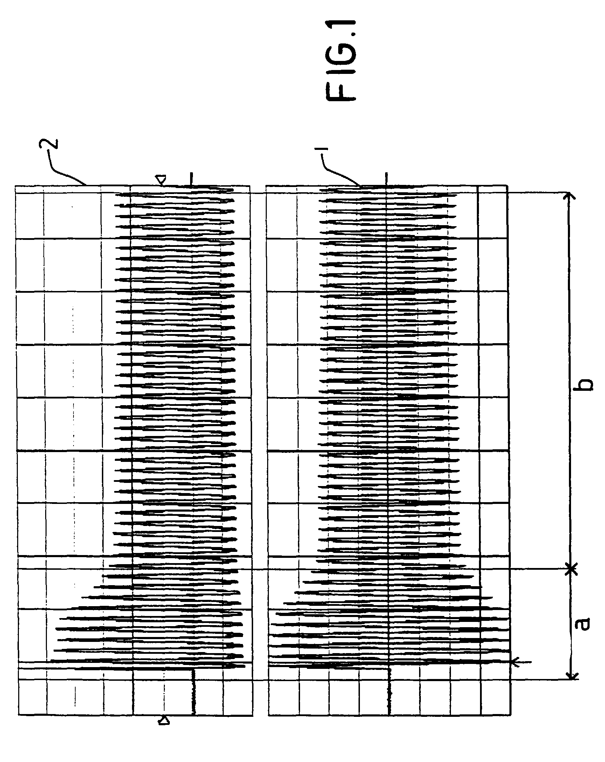

The idea on which the control is based is to exploit the electric-physical operation of the motor. For the understanding of the invention, reference is made to the second quadrant in FIG. 1 wherein, designated at 1 is the state of the current in a motor. The current always has a start-up phase a upon starting the motor, when current is at its maximum, and a maintenance phase b, in which the current value is definitely lower.

It is stressed that maximum absorption of current could also occur during the maintenance phase, should the motor be jammed.

The implemented algorithm simply tests that the condition of normal operation is satisfied and, upon anomalies occurring in either the start-up or the maintenance phase, it carries out a prealarm procedure in which it carries out a series of motor control attempts with an aim to release the jammed motor.

The control system of this invention is comprised of two fundamental parts; a current sensing device series connected to the load (motor) and a software routine which samples and monitors the current state of said circuit.

The number of required electronic components is minimised, remitting the control function to the software.

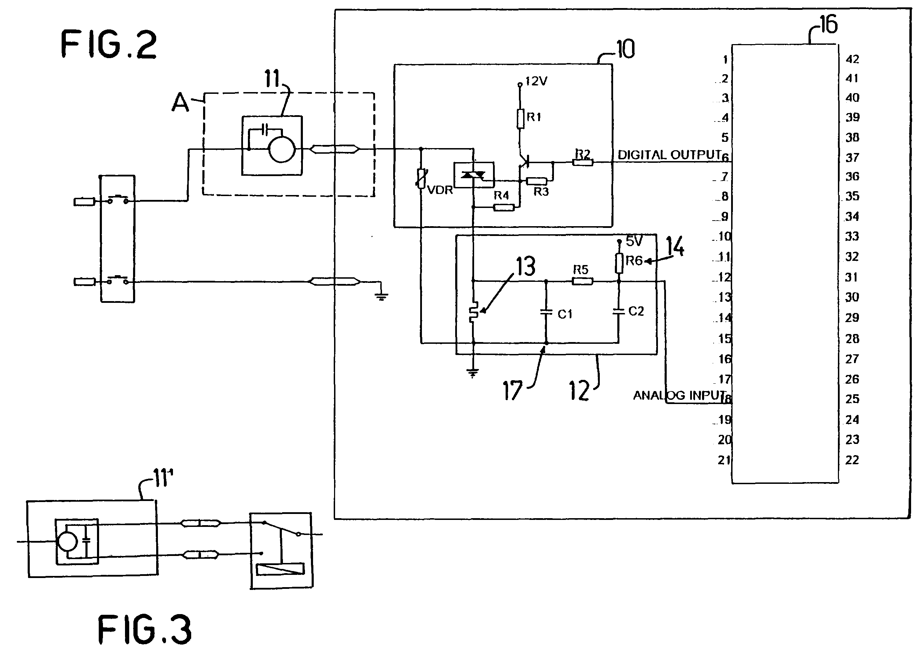

In FIG. 2 it is shown that a simple current sensing device 12 is added to a conventional circuit 10 for controlling the motor 11. The sensing device is composed of a shunt 13 series connected to the control branch, a π low-pass filter 17 composed of a first capacitor C1, a resistor R5 and a second capacitor C2, and an optional pull up device 14 for cutting off the control from part of the microprocessor 16.

The procedure provides for constant control of current in the branch of the washing motor. In fact, from the instant the load is activated to when it goes off, the output value of the current sensing device 12 is monitored (see the quadrant 2 of FIG. 1 showing the voltage of shunt 13), controlling that it follows a classic routine with a start-up phase followed by a maintenance phase and that no current peaks occur.

To control current by way of a simple method, experimentally determined thresholds have to be fixed. The monitored current must not exceed these thresholds. Reaching these limits for a prolonged period determines a condition of anomaly.

In this manner the system is critical as it is affected by the electric circuit parameters, i.e. temperature derating, supply voltage variation derived from the components, etc..

The method of this invention avoids said problems as it analyses the current state and calculates intervention thresholds every time it is activated. Accordingly, the system is self-adapting and is immune to any variation of the aforecited parameters.

The control is composed of the following phases:
a) continuous current monitoring;
b) check at start-up under starting-up conditions;
c) check of constant current in the maintenance phase;
d) prealarm phase;
e) alarm phase.

Current monitoring is the routine which cyclically samples and reads the sensing device output current value. It makes provision for filtering algorithms to avoid reading errors due to disturbances.

The start-up check is the routine that is activated at motor start-up. It analyses the state of the current value in the start-up phase by calculating the normal operation threshold. If the maximum absorption condition occurs for more than 3 seconds, the prealarm routine is activated.

The maintenance check is the routine that is activated at the end of the motor start-up phase. This check controls that the current value is kept under the calculated limits. If a maximum current absorption condition occurs for more than 3 seconds, the prealarm routine is activated.

The prealarm phase is the routine which is activated in anomaly conditions. It provides for 10 attempts of driving the motor alternated by pauses (at present, driving and pause periods last 3 seconds each). If all attempts have no effect, the anomaly condition is determined, whereby the alarm phase is activated.

The motor of FIG. 2 is one of known kind with a single direction of rotation. The variant embodiment of FIG. 3 shows a motor 11' (also of known kind) capable of operating in either direction of rotation. In this case, during the prealarm phase, instead of said pause the motor control is activated for driving the motor in the way opposite to that required. This action may facilitate the release of the jammed motor. The remainder of the routine is exactly like the one described above.

The alarm phase is the final phase in dealing with the anomaly of the motor. During this phase, all functions of the dish-washing machine are deactivated. A visual signal is emitted to inform the user about the machine condition. Two kinds of visualisation are provided for distinguishing the two conditions of anomaly which may occur. One indicates that the motor was jammed in the start-up phase, the other that it jammed during normal washing operation.

## Claims

1. An electronic control system for controlling the operational condition of the washing motor of a dish-washing machine of the type in which the washing motor (11, 11') is driven by an electronic circuit (10) connected to a microprocessor (16), characterised in that a current sensing device (12), consisting of a shunt (13) and a π low-pass filter (17), is series connected to the driving branch of the electronic circuit (10) and is connected to the microprocessor (16) for carrying out constant and continuous control of the state of the current in the motor during the start-up phase and the maintenance phase and for detecting possible anomaly conditions.

2. A control system as claimed in claim 1, characterised in that the filter (17) is composed of two capacitors (C1, C2) and a resistor (R5).

3. A control system as claimed in claim 1, characterised in that the current sensing device (12) also provides for a pull up device (14) for cutting off said control from part of the microprocessor (16).

4. A control system as claimed in claim 1, characterised in that the washing motor (11) has only one direction of rotation.

5. A control system as claimed in claim 1, characterised in that the washing motor (11') has both directions of rotation.
